# EUROPÄISCHE PATENTSCHRIFT

(11) **EP 3 490 134 B1**
(45) Veröffentlichungstag und Bekanntmachung des Hinweises auf die Patenterteilung: **07.07.2021**
(21) Anmeldenummer: 18208059.8
(22) Anmeldetag: 23.11.2018
(51) Int. Cl.: H02N 2/00, H02N 2/02

(54) **VORGESPANNTER TRÄGHEITSANTRIEB UND ENTSPRECHENDES VERFAHREN**
PRETENSIONED INERTIAL DRIVE AND METHOD THEREFOR
ENTRAÎNEMENT PAR INERTIE PRÉCONTRAINT ET PROCÉDÉ CORRESPONDANT

(30) Priorität: 23.11.2017 DE 102017127745
(43) Veröffentlichungstag der Anmeldung: 29.05.2019
(73) Patentinhaber: Picofine GmbH, 26135 Oldenburg (DE)
(72) Erfinder: Kortschack, Axel, 26123 Oldenburg (DE)
(74) Vertreter: Eisenführ Speiser

(56) Entgegenhaltungen:
- DE-A1- 19 702 066
- DE-A1-102009 013 849
- DE-B3-102012 221 891
- DE-B3-102014 205 280
- DE-B3-102014 205 280
- US-A1- 2014 043 515

## Beschreibung

Die vorliegende Erfindung betrifft das Gebiet von piezoelektrischen oder elektrostriktiven Antrieben und insbesondere eine Antriebsvorrichtung zur linearen Positionierung eines stangenförmigen Objekts und ein entsprechendes Antriebsverfahren, also etwa einen Antrieb für eine Trägheits- oder Mehraktuatorantriebsvorrichtung zum direkten Antreiben eines makroskopisch zu bewegenden Objekts.

Solche Antriebe werden in diversen Fällen zum hochpräzisen Positionieren von Objekten herangezogen, wobei häufig ausgenutzt wird, dass diese Antriebe sehr kompakt bauen können, die Position auch im stromlosen Zustand halten können und auch in extremen Umweltbedingungen, wie z.B. im Vakuum und bei Anwesenheit von starken und fluktuierenden Magnetfelder, eingesetzt werden können.

Ein Aktuator des Vibrationstyps gemäß US 2014/0043515 A1 umfasst ein Vibrationselement, ein angetriebenes Element, das ausgestaltet ist, sich durch eine Vibration des Vibrationselements relativ zum Vibrationselement zu bewegen, ein mit dem angetriebenen Element verbundenes Ausgabeelement, einen in ein Durchgangsloch des Vibrationselements eingeführten Schaft, ein mit dem Schaft gekoppeltes Fixierelement, das dazu ausgestaltet ist, das Ausgabeelement zu stützen, und eine Spiralfeder, die zwischen dem angetriebenen Element und dem Ausgabeelement vorgesehen ist und ausgestaltet ist, das angetriebene Element in Druckkontakt mit dem Vibrationselement zu bringen. Die Spiralfeder umfasst an einem ihrer Endabschnitte einen ersten Endwindungsabschnitt mit mehreren Windungen. Die Spiralfeder ist mit dem Ausgabeelement an dem ersten Endwindungsabschnitt verbunden. Die Dicke des Endwindungsabschnitts ist größer als ein Spalt zwischen dem angetriebenen Element und dem Ausgabeelement.

DE 10 2014 205 280 B3 betrifft einen Trägheitsantrieb, umfassend ein längenveränderliches, insbesondere piezoelektrisches Aktorelement, ein Rahmenelement mit einem Abstützungsabschnitt, an dessen Abstützungsfläche sich ein erster Endabschnitt des Aktorelements abstützt, und mit einem Umformungsabschnitt, an dessen Anlagefläche ein zweiter Endabschnitt des Aktorelements, der dem ersten Endabschnitt des Aktorelements gegenüberliegt, anliegt, wobei der Umformungsabschnitt einen Gelenkabschnitt aufweist, und ein an dem Umformungsabschnitt des Rahmenelements angeordnetes flaches, vorzugsweise ebenes und langgestrecktes Federelement mit einem Reibabschnitt an seinem freien Ende, und ein anzutreibender Reibkörper, der sich in direktem oder indirektem mechanischem Kontakt mit dem Reibabschnitt befindet, wobei die Längenänderung des Aktorelements eine rotatorische Bewegung des Umformungsabschnitts um den Gelenkabschnitt hervorruft, die über das Federelement auf den Reibabschnitt zum Antrieb des anzutreibenden Reibkörpers übertragen wird, wobei der Reibabschnitt in einer der Anlagefläche abgewandten Richtung beabstandet zu der Anlagefläche angeordnet ist.

DE 197 02 066 A1 betrifft einen piezoelektrischen Injektor für Kraftstoffeinspritzanlagen von Brennkraftmaschinen, mit einem unter Federvorspannung im Ventilgehäuse geführten Piezo-Aktuator, der über ein Betätigungsteil ein Verschlussstück auf seinen Ventilsitz drückt, wobei das Betätigungsteil aus einem den Piezo-Aktuator durchsetzenden Druckstift mit auf dem Piezo-Aktuator aufliegendem Kopfteil besteht, Druckstift und Piezo-Aktuator gleiche Länge und gleiches Keramikmaterial aufweisen und das Verschlussstück durch den bei geladenem Zustand ausgedehnten Piezo-Aktuator von seinem Ventilsitz abhebbar ist.

DE 10 2009 013 849 A1 betrifft eine Vorrichtung mit wenigstens einem röhrenförmigen Piezoelement zur elektromechanischen Positionierung eines Läufers im Innern des Piezoelements. Diese ist gekennzeichnet durch wenigstens ein mit dem Piezoelement verbundenes elastisches Reibungsmittel zur Ausübung einer Normalkraft auf den Läufer. Ein Verfahren zur Steuerung der Vorrichtung ist in DE 10 2009 013 849 A1 ebenfalls offenbar.

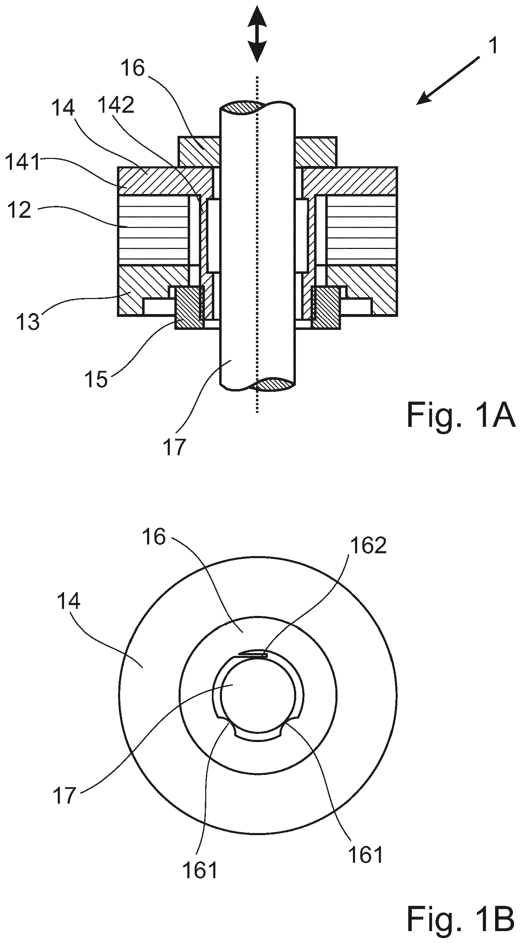

DE102012221891 betrifft ein Verfahren und einen Antrieb zur linearen oder rotatorischen Positionierung eines zu bewegenden Objekts mittels piezoelektrischer Aktorik (Abb.1).

DE 10 2014 205 280 B3 betrifft einen Trägheitsantrieb, umfassend ein längenveränderliches, insbesondere piezoelektrisches Aktorelement, ein Rahmenelement mit einem Abstützungsabschnitt, an dessen Abstützungsfläche sich ein erster Endabschnitt des Aktorelements abstützt, und mit einem Umformungsabschnitt, an dessen Anlagefläche ein zweiter Endabschnitt des Aktorelements, der dem ersten Endabschnitt des Aktorelements gegenüberliegt, anliegt, wobei der Umformungsabschnitt einen Gelenkabschnitt aufweist, und ein an dem Umformungsabschnitt des Rahmenelements angeordnetes flaches, vorzugsweise ebenes und langgestrecktes Federelement mit einem Reibabschnitt an seinem freien Ende, und ein anzutreibender Reibkörper, der sich in direktem oder indirektem mechanischem Kontakt mit dem Reibabschnitt befindet, wobei die Längenänderung des Aktorelements eine rotatorische Bewegung des Umformungsabschnitts um den Gelenkabschnitt hervorruft, die über das Federelement auf den Reibabschnitt zum Antrieb des anzutreibenden Reibkörpers übertragen wird, wobei der Reibabschnitt in einer der Anlagefläche abgewandten Richtung beabstandet zu der Anlagefläche angeordnet ist.

Es ist bekannt, Trägheitsantriebe (z.B. Piezo-Stick-Slip-Antriebe) mit elektrischen Signalen zu versorgen, um ein zu positionierenden Objekt mit einer hohen Bewegungsauflösung zu bewegen.

Beispielhafte Ausführungen sind z.B. aus "Dynamic piezoelectric translation devices" von D.W. Pohl (Review of Scientific Instruments, vol. 58 (1), Januar 1987, Seiten 54 bis 57) und WO 98/19347 bekannt.

Ebenfalls ist es bekannt, ein Objekt durch den Einsatz mehrerer Aktuatoren mit einer hohen Bewegungsauflösung zu positionieren, wobei hier die mehreren Aktoren in einer geeigneten Weise zusammenarbeiten, um gemeinsam ein zu positionierendes Objekt zu bewegen. Dabei handelt es sich um sogenannte Mehraktuatorantriebe. Beispiele hierzu finden sich in EP 0 750 356 A1, WO 93/19494 A1 und DE 10 2009 013 849 A1.

Die Bewegungen der Aktoren werden über Reibflächen auf ein zu positionierendes Objekt übertragen, welches ununterbrochen im Reibkontakt mit den Reibflächen steht.

Ebenfalls zu den Trägheitsantrieben gehören Antriebe, die Resonanzeffekte im Antrieb ausnutzen, aber anders als herkömmliche Ultraschallantriebe einen permanenten Reibkontakt zwischen dem anzutreibenden Objekt und einem antreibenden Reibkörper aufweisen. In der Regel werden bei dieser Art der Antriebe Eigenschwingungen überlagert, die durch eine Überlagerung von Sinussignalen der Ansteuerung erzielt werden, wobei anstatt von Sinussignalen auch andere Kurvenformen gewählt werden können. Beispielhafte Ausführungen sind z.B. aus "A miniaturized resonant-type smooth impact drive mechanism actuator" von Morita, et al., (Sensors and Actuators A: Physical 178 (2012), S. 188-192) und "Multi-degree-of-freedom ultrasonic motors for mass-consumer devices" von Bansevicius, R.; Blechertas, V. (Journal of Electroceramics 20 (2008), Nr. 3, S. 221-224) bekannt.

Es sind insbesondere Trägheitsantriebe bekannt, die stangenförmige Objekte bewegen, wie sie zum Beispiel in EP 0 792 203 B1 und EP 2 606 568 B1 beschrieben werden.

In der Lehre von EP 0 792 203 B1 nimmt ein röhrchenförmiger Piezoaktuator eine röhrchenförmige Lauffläche auf, die in das Innere des Piezoröhrchen ragt. Innerhalb der Lauffläche befindet sich das zu positionierende Objekt, welches so verformt ist, dass es sich mit einer geeigneten Kraft in die röhrchenförmige Lauffläche klemmt, so dass es bei Ansteuerung des Piezoaktuators zu einer Relativbewegung zwischen der Lauffläche und dem zu positionierenden Objekt kommt.

Bezüglich der erzielbaren Positionierkräfte ist diese Art des Antriebs nicht sonderlich leistungsfähig. So darf z.B. die im Aktuator befindliche Lauffläche nur mit einer so geringen Beschleunigung beaufschlagt werden, dass der Aktuator nicht zerstört wird. Insbesondere für den Fall, dass ein Mehrlagenaktuator eingesetzt werden soll, was von Vorteil ist, wenn mit geringen Ansteuerspannungen gearbeitet werden soll, ist der Aktuator sehr empfindlich auf Zugbelastungen. Bei leistungsfähigen Piezo-Stick-Slip-Antrieben sind die auftretenden Beschleunigungen der Antriebsfläche und damit die erzeugten und auf den Aktuator wirkenden Kräfte sehr hoch.

EP 2 606 568 B1 beschreibt einen Antrieb, der ebenfalls ein stangenförmiges Objekt positioniert. Hier wird über eine Vorspannung eines ringförmigen mehrlagen Piezoaktuators dafür gesorgt, dass der Piezoaktuator vor zu großen Zugbelastungen geschützt wird, so wie es für industrietaugliche Piezo-Stick-Slip-Antriebe üblich ist. In EP 2 606 568 B1 soll ein einfacher Aufbau realisiert werden, bei dem das den Aktuator vorspannende Objekt zwischen dem Aktuator und einem Gehäuse gespannt wird. So lässt sich zwar ein einfacher Aufbau realisieren, jedoch aufgrund des notwenigen, alle sonstigen Komponenten umfassenden Gehäuses kann der Antrieb nicht klein bauen. Insbesondere ist das Verhältnis von Aktuatorvolumen zum Gesamtvolumen des Antriebs ungünstig. Ein Antrieb kann insbesondere dann im Verhältnis zum Volumen stark bauen, wenn ein großer Anteil des Volumens vom aktiv benutzten Volumen des Piezoaktuator eingenommen wird.

Nachteilig an diesen bekannten Lösungen ist, dass der Antrieb entweder schwach ist, da keine hohen Beschleunigungen erlaubt sind, also keine hohen Reibkräfte überwunden werden können, oder bauartbedingt ein ungünstiges Verhältnis zwischen Volumen des Aktuators und Gesamtvolumen aufweist.

Ein der vorliegenden Erfindung zugrundeliegendes Ziel ist es, einen bezüglich des Bauvolumens starken Antrieb bereitzustellen.

Es ist daher gewünscht, eine Lösung vorzustellen, die eine einfach zu bauende Trägheitsantriebsvorrichtung erlaubt, die etwa zu einem direkten Antrieb eines stangenförmigen Objektes geeignet ist, wobei der Antrieb ein günstiges Verhältnis zwischen Aktuatorvolumen und Gesamtbauvolumen aufweist.

Erfindungsgemäß wird nach einem ersten Aspekt eine Trägheitsantriebsvorrichtung zur Positionierung eines Objekts vorgeschlagen, wie sie in Anspruch 1 definiert ist.

Erfindungsgemäß wird nach einem zweiten Aspekt ein Verfahren zur Positionierung eines Objekts vorgeschlagen, wie es in Anspruch 10 definiert ist.

Ein Teil des Hintergrunds der vorliegenden Erfindung findet sich in den folgenden Überlegungen.

Ziel der Erfindung ist es, einen Antrieb zu realisieren, bei dem der Aktuator eine vorzugsweise kreisrunde Öffnung aufweist, durch die das anzutreibende, stangenförmige Objekt hindurch- oder hineinragt. Um den Aktuator des Antriebs mit hohen Beschleunigungen beaufschlagen zu können, ohne dass der Aktuator zerreißt, wird der Aktuator mit Spannmitteln, die durch die Öffnung des Aktuators hindurchragen, vorgespannt.

Da die Mittel zur Vorspannung durch die Öffnung des Aktuators hindurchragen, nimmt die Vorspannvorrichtung (bzw. das Spannelement) im Verhältnis zum Aktuatorvolumen nur ein geringes Volumen ein, was dazu führt, dass das Aktuatorvolumen im Verhältnis zum Gesamtvolumen des Antriebs groß ist, was von Vorteil für einen kräftigeren Antrieb ist, weil die mit dem verhältnismäßig großen Aktuator erzeugbare große Kraft hohe Beschleunigungen erlaubt, was wiederum heißt, dass bei einer gegebenen Masse des anzutreibenden Objektes höhere Kräfte des Antriebs zu erzeugen sind.

Hierbei kann im Allgemeinen sogar auf ein Gehäuse, wie es in EP 2 606 568 B1 notwendig ist, ganz verzichtet werden, so dass sich robuste, stark miniaturisierte Antriebe realisieren lassen.

Die Erfindung erlaubt eine Trägheitsantriebsvorrichtung und ein diese nutzendes Verfahren zur Positionierung eines Objekts, wobei eine im Verhältnis zum Gesamtvolumen hohe Kraft ausgeübt werden kann, wobei zudem die erfindungsgemäße Trägheitsantriebsvorrichtung einfach gefertigt werden kann und eine kompakte Bauweise aufweist.

In einer vorteilhaften Ausgestaltung eines Aspekts der Erfindung sind das Reibelement und das Spannelement integral ausgeführt.

Auch wenn die Funktionen von Reibelement und Spannelement an sich unterschiedlich sind, können diese Funktionen auch von einem einzelnen Bauteil oder einer integralen Bauteilgruppe ausgeübt werden.

In einer anderen vorteilhaften Ausgestaltung eines Aspekts der Erfindung ist das Reibelement über das Spannelement mit dem Aktuator verbunden.

Wenn das Spannelement in Längsrichtung, also in Richtung der Bewegung des Aktuators bzw. des zu positionierenden Objekts, den Aktuator einfasst, kann das Reibelement in einfacher Weise am Spannelement angebracht werden, um mit dem Aktuator verbunden zu sein. Ist das Reibelement mehrteilig ausgeführt, kann in Längsrichtung vor und hinter dem Aktuator jeweils ein Teilabschnitt des Reibelements am Spannelement angebracht sein.

In einer anderen vorteilhaften Ausgestaltung eines Aspekts der Erfindung ist Spannelement ausgestaltet, die Druckspannung über das mit dem Aktuator verbundene Reibelement auf den Aktuator auszuüben.

Das Spannelement kann zusätzlich zum Aktuator auch das Reibelement einspannen, so dass Aktuator und Reibelement gemeinsam vom Spannelement umfasst werden. Hierbei ist das Spannelement mit Aussparungen oder dergleichen versehen, durch die das Reibelement mit dem zu positionierenden Objekt in Reibkontakt steht.

In einer anderen vorteilhaften Ausgestaltung eines Aspekts der Erfindung ist das Reibelement unabhängig vom Spannelement mit dem Aktuator verbunden und ist das Spannelement dazu ausgestaltet, die Druckspannung unabhängig vom Reibelement auszuüben.

Bei geeigneter räumlicher Ausformung und Anordnung von Reibelement und Spannelement können diese hinsichtlich des Aktuators gewissermaßen parallel angeordnet sein.

Ist etwa das Reibelement als kraftübertragendes Objekt direkt am Aktuator angeordnet, kann es segmentweise durch das Spannelement hindurch reichen. Dafür weist das Spannelement im Umfang entsprechende Öffnungen auf.

In einer anderen vorteilhaften Ausgestaltung eines Aspekts der Erfindung ist das Spannelement für eine einstellbare Druckspannung ausgestaltet und ist insbesondere mit einer zur Einstellung der Druckspannung vorgesehenen Verschraubung ausgestattet.

Die Druckspannung kann in einfacherweise durch eine variable Einstellbarkeit der Ausdehnung des Spannelements in Längsrichtung in gewünschter Weise angepasst werden, ohne dass ein Bauteilaustausch oder ähnliches nötig wäre. Eine solche Einstellbarkeit kann insbesondere durch eine Verschraubung einfach realisiert werden.

In einer anderen vorteilhaften Ausgestaltung eines Aspekts der Erfindung weist das Spannelement zur Bewirkung der Druckspannung ein integrales Federelement, insbesondere infolge einer Dehnung, Biegung und/oder Torsion, und/oder ein separates Federelement auf.

Es kann vorgesehen sein, dass das Spannelement einteilig mit einem integrierten Federelement ausgestattet ist, um die gewünschte Druckspannung zu erzeugen. Es ist auch möglich, dass das Spannelement mehrteilig ausgeführt ist und für eine Aufnahme eines separaten Federelements als weiterem Teil des Spannelements ausgestaltet ist. Eine Kombination dieser Möglichkeit ist ebenfalls vorstellbar.

In einer anderen vorteilhaften Ausgestaltung eines Aspekts der Erfindung ist das Reibelement für eine Einstellbarkeit einer Reibungskraft zwischen dem Reibelement und dem zu positionierenden Objekt ausgestaltet.

Die Einstellbarkeit der Reibungskraft erlaubt eine Anpassung der Trägheitsantriebsvorrichtung an unterschiedliche Anforderungen und ermöglicht zudem eine Kompensation von Abnutzung oder Ermüdung im Betrieb.

In einer anderen vorteilhaften Ausgestaltung eines Aspekts der Erfindung ist der Innenbereich vom Aktuator ganz oder teilweise umschlossen.

Es ist erfindungsgemäß nicht notwendig, dass der Aktuator den durch ihn definierten Innenbereich vollständig umschließt.

In einer anderen vorteilhaften Ausgestaltung eines Aspekts der Erfindung ist ein Trägheitsantriebssystem mit wenigstens zwei miteinander verbundenen, erfindungsgemäßen Trägheitsantriebsvorrichtungen vorgesehen.

Die hierbei mehreren zusammengeschlossenen Trägheitsantriebsvorrichtungen können hinsichtlich der Ansteuerung der Aktuatoren gleichsinnig und/oder gegensinnig angeordnet sein, wobei eine entsprechende Steuerung als solche aus vergleichbaren Mehraktorantrieben aus dem Stand der Technik bekannt ist. Vorteilhaft an einem Zusammenschließen mehrerer Trägheitsantriebsvorrichtungen ist zudem, dass damit eine gegenseitige Lagerung des zu positionierenden Objekts verbunden sein kann.

Der Aktuator kann monolithisch oder als Stapelaktuator ausgeführt sein. Die Erfindung ist zudem nicht darauf beschränkt, dass der Aktuator als solcher einteilig ausgestaltet ist, da der Aktuator auch mehreren parallel-geschalteten Teilaktuatoren bestehen kann.

Insbesondere ringförmige Aktuatoren (mit einem kreisförmigen Umfang und einer kreisförmigen Öffnung in der Mitte) und rechteckige Aktuatoren (mit einer kreisförmigen Öffnung oder Aussparung in der Mitte) sind einzeln oder im Stapel kommerziell erhältlich. Die Erfindung ist allerdings nicht auf diese Außenformen beschränkt, und der oder die Aktuatoren können beliebig andere Formen aufweisen, soweit sichergestellt ist, dass eine Öffnung vorhanden ist, durch die das Spannelement reichen kann. Der Aktuator als Ganzes weist erfindungsgemäß eine Öffnung bzw. den Innenbereich auf, diese Öffnung bzw. dieser Innenbereich muss aber nicht zwangsweise vollständig vom Aktuator umfasst werden. Bei geeigneter Formgestaltung des Aktuators (z.B. mit einer C-Form) oder durch einen Aufbau des Aktuators durch mehrere aus Sicht der Bewegung nebeneinander angeordnete Teilaktuatoren ist es nicht nötig, dass der Aktuator bzw. die Teilaktuatoren Durchgangslöcher oder dergleichen aufweisen, um den Innenbereich zu bilden.

Ein Gehäuse ist zwar nicht notwendig, von der Erfindung aber auch nicht per se ausgeschlossen. So kann ein Gehäuse z.B. vorgesehen werden, um den Aktuator vor direkter Berührung und Dreck zu schützen. Anders als in EP 2 606 568 B1 muss das Gehäuse hierbei allerdings keine strukturellen Lasten aufnehmen und muss nicht das Spannelement stützen oder erlauben, dass über das Gehäuse die Vorspannung einzustellen ist. Dementsprechend kann das Gehäuse hier deutlich weniger aufwändig ausgestaltet sein.

Das kraftübertragende Reibelement kann mit einem gegenüber einem Hauptteil des Reibelements weiteren Material oder Element versehen werden, welches zwischen dem Hauptteil und dem anzutreibenden Objekt angeordnet wird, mit dem Ziel, eine stabile, verschleißfeste Reibpaarung zu erzeugen.

Das Reibelement muss das anzutreibende Objekt nicht zwangsweise vollständig umfassen. Insbesondere kann vorgesehen sein, dass sowohl der Aktuator als auch das Reibelement - wie auch die anderen Elemente der Antriebsvorrichtung - jeweils den Innebereich nur teilweise umschließen, z.B. jeweils in C-Form, wobei dies ein rotatorisches Antreiben bzw. Positionieren eines scheibenförmigen Objektes erlaubt.

Das anzutreibende bzw. zu positionierende Objekt kann radial federnd ausgestaltet werden, wie z.B. im Falle einer Spannhülse. In einem solchen Fall kann das Reibelement auch ohne einen federnden Bereich oder dergleichen zur Erzeugung der Reibkraft ausgestaltet sein.

Das anzutreibende bzw. zu positionierende Objekt kann eine kreisrunde Stange sein. Es sind aber auch andere Formen, wie z.B. dreieckige Stangen und anderer beliebige Formen denkbar, was von Vorteil sein kann, da damit einfach ein Verdrehen des anzutreibenden Objektes innerhalb des Reibelements verhindert werden kann.

Im Sinne einer möglichst optimalen Nutzung des zur Verfügung stehenden Raumes sollte der Querschnitt des Innenbereichs in seiner Form im Wesentlichen dem Querschnitt des zu positionierenden Objekts im Bereich der Trägheitsantriebsvorrichtung entsprechen.

Merkmale vorteilhafter Ausführungsformen der Erfindung sind insbesondere in den Unteransprüchen definiert, wobei weitere vorteilhafte Merkmale, Ausführungen und Ausgestaltungen für den Fachmann zudem aus den obigen Erläuterung und der folgenden Diskussion zu entnehmen sind.

Im Folgenden wird die vorliegende Erfindung anhand von in den Figuren dargestellten Ausführungsbeispielen weiter illustriert und erläutert. Hierbei zeigt
- Fig. 1A: eine schematische Querschnittdarstellung zur Illustration eines ersten Ausführungsbeispiels der erfindungsgemäßen Trägheitsantriebsvorrichtung,
- Fig. 1B: eine schematische Draufsicht zur Illustration des ersten Ausführungsbeispiels der erfindungsgemäßen Trägheitsantriebsvorrichtung,
- Fig. 2: eine schematische Querschnittdarstellung zur Illustration eines zweiten Ausführungsbeispiels der erfindungsgemäßen Trägheitsantriebsvorrichtung,
- Fig. 3: eine schematische Querschnittdarstellung zur Illustration eines dritten Ausführungsbeispiels der erfindungsgemäßen Trägheitsantriebsvorrichtung,
- Fig. 4: eine schematische Querschnittdarstellung zur Illustration eines vierten Ausführungsbeispiels der erfindungsgemäßen Trägheitsantriebsvorrichtung,
- Fig. 5: eine schematische Querschnittdarstellung zur Illustration eines fünften Ausführungsbeispiels der erfindungsgemäßen Trägheitsantriebsvorrichtung,
- Fig. 6: eine schematische Querschnittdarstellung zur Illustration eines sechsten Ausführungsbeispiels der erfindungsgemäßen Trägheitsantriebsvorrichtung,
- Fig. 7: eine schematische Querschnittdarstellung zur Illustration eines Ausführungsbeispiels des erfindungsgemäßen Trägheitsantriebssystems und
- Fig. 8: ein schematisches Ablaufdiagramm eines Ausführungsbeispiels des erfindungsgemäßen Verfahrens zur Positionierung eines Objekts.

In den beiliegenden Zeichnungen sowie den Erläuterungen zu diesen Zeichnungen sind einander entsprechende bzw. in Beziehung stehende Elemente - soweit zweckdienlich - mit jeweils entsprechenden oder ähnlichen Bezugszeichen gekennzeichnet, auch wenn sie in unterschiedlichen Ausführungsbeispielen zu finden sind. Hierbei wird zudem auf Wiederholungen entsprechender Beschreibungen oder Erläuterungen verzichtet, da der Fachmann erkennt, dass die Beschreibungen oder Erläuterungen zu einer oder mehreren vorherigen Ausführungsbeispielen auch hier zutreffen.

Fig. 1A zeigt eine schematische Querschnittdarstellung zur Illustration eines ersten Ausführungsbeispiels der erfindungsgemäßen Trägheitsantriebsvorrichtung.

Die Trägheitsantriebsvorrichtung 1 weit einen Aktuator 12 mit einer vorzugsweisen kreisrunden Öffnung auf, die damit einen Innenbereich des Aktuators 12 definiert. Die Hauptbewegung des Aktuators 12 ist in Richtung des Doppelpfeils, welches auch die Bewegungsrichtung eines von der Trägheitsantriebsvorrichtung 1 anzutreibenden Objektes 17 ist.

Auf einer seiner Seiten steht der Aktuator 12 mit einer Basis 13 in Kontakt, die als ein Beispiel einer stationären Komponente des Antriebs angesehen werden kann.

Hier sei angemerkt, dass selbstverständlich auch das Objekt 17 stationär gehalten werden kann, wobei dann werden die übrigen Komponenten als beweglich zu betrachten sind.

Der Aktuator 12 ist an seiner Stirnseite mit der Basis 13 fest verbunden, z.B. verklebt, wobei dies allerdings nicht essentiell für die Erfindung ist.

Die dieser Stirnseite gegenüberliegende Seite des Aktuators 12 steht mit einem Spannelement 14 in Kontakt, so dass der mit dem Aktuator 12 in Kontakt stehende Kontaktteil 141 des Spannelements 14 bei der Auslenkung des Aktuators 12 mitbewegt wird.

Vorzugsweise ist der Aktuator 12 mit der zweiten Stirnseite mit dem Spannelement 14 fest verbunden, z.B. verklebt.

In dem ersten Ausführungsbeispiel weist das Spannelement 14 einen elastischen Bereich 142 als integrales Federelement auf, der bei der Streckung des Aktuators 12 ebenfalls gesteckt wird und sich wieder zusammenzeiht, wenn der Aktuator 12 sich entlang der Bewegungsrichtung wieder komprimiert.

Der elastische Bereich 142 kann z.B. dadurch elastisch ausgeführt werden, indem der Bereich 142 ausreichend dünnwandig erzeugt wird oder indem der Bereich 142 z.B. geeignete Festkörpergelenke aufweist.

Die Streckung wird eingebracht, da das durch den Aktuator 12 hineinragende Spannelement 14 jenseits des elastischen Bereichs 142 mit der Basis 13 in Kontakt steht, z.B. über eine Schraubverbindung oder Verschraubung 15. Selbstverständlich können auch andere Verbindungsarten, wie z.B. Kleben, Löten, Klemmen genutzt werden.

Die in Fig. 1 dargestellte Verschraubung 15 erlaubt eine Einstellung der Kraft, mit der der Aktuator 12 über die Streckung des Bereichs 142 des Spannelements 14 vorgespannt wird.

Ein Reibelement 16 als ein kraftübertragendes Objekt ist mit dem vom Aktuator 12 lokal beweglichen Kontaktteil 141 des Spannelements 41 verbunden. Das Reibelement 16 steht im Reibkontakt mit dem zu positionierenden Objekt 17. Vorzugsweise weist das Objekt 17 und/oder das Reibelement 16 Mittel auf (integral oder als Baugruppe), mit denen die Anpresskraft zwischen dem Reibelement 16 und dem anzutreibenden Objekt 17 eingestellt werden kann. Das können z.B. Federn und Schrauben sein.

Eine Draufsicht (Figur 1B) auf das erste Ausführungsbeispiel zeigt skizzenhaft eine mögliche Ausführung eines Mittels zum Einstellen der Kraft, ohne dass dabei notwendigerweise sinnvolle Größenverhältnisse dargestellt sind. Zu sehen ist, dass das Reibelement 16 als kraftübertragendes Objekt Reibkontakte 161 mit dem anzutreibenden Objekt 17 aufweist. In dem Beispiel ist ein weiterer Reibkontakt über einen Ausleger 162 realisiert, über den auch die Reibkraft eingestellt werden kann, z.B. in dem dieser passend elastisch verformt werden muss, um das anzutreibende Objekt 17 in das Reibelement 16 schieben zu können. Von Vorteil ist es, wenn die Anpresskraft eingestellt werden kann, indem z.B. Schrauben eingesetzt werden, da das ein einfaches, nachträgliches Justieren der Kraft ermöglicht.

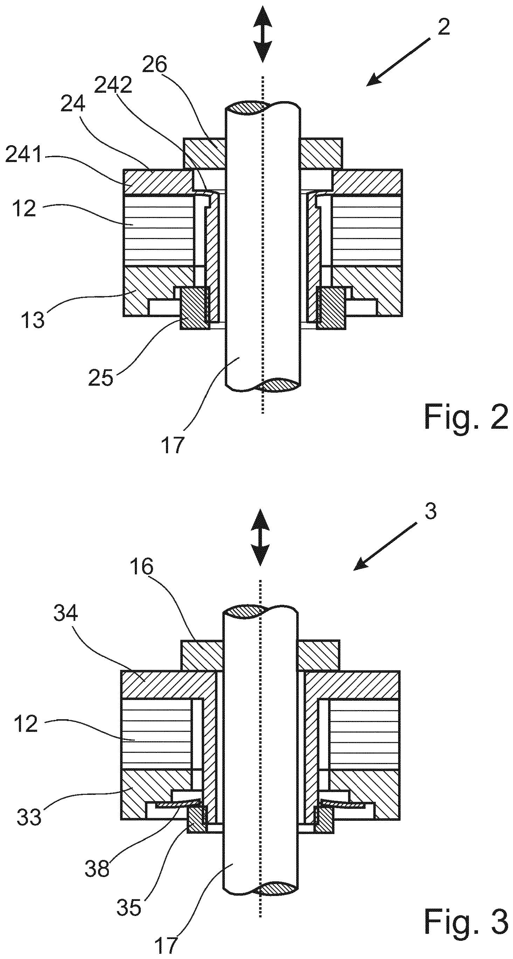

Fig. 2 zeigt eine schematische Querschnittdarstellung zur Illustration eines zweiten Ausführungsbeispiels der erfindungsgemäßen Trägheitsantriebsvorrichtung.

Die Trägheitsantriebsvorrichtung 2 des zweiten Ausführungsbeispiels ähnelt der des ersten Ausführungsbeispiels (Trägheitsantriebsvorrichtung 1). Anstelle der Dehnung und Stauchung eines Bereichs des integralen Federelements 142 des Spannelements 14, liegt hier bei einem Spannelement ein Bereich 242 vor, der auf Biegung beansprucht wird. Selbstverständlich muss dieser Bereich nicht notwendigerweise integral hergestellt werden, wie es hier in Fig. 2 dargestellt ist. Stattdessen kann auch beispielsweise eine Tellerfeder als ein separates Federelement eingesetzt werden, die über ein Vorspannmittel in Form beispielsweise einer hier vorliegenden Verschraubung 25 gespannt wird, so dass der Aktuator 12 die notwenige Vorspannung erfährt.

Fig. 3 zeigt eine schematische Querschnittdarstellung zur Illustration eines dritten Ausführungsbeispiels der erfindungsgemäßen Trägheitsantriebsvorrichtung.

Die Trägheitsantriebsvorrichtung 3 unterscheidet sich insofern von der Trägheitsantriebsvorrichtung 2 des zweiten Ausführungsbeispiels, als das zum einen die Vorspannung auf den Aktuator 12 über ein separates Federelement 38 aufgebaut wird, welches über eine Verschraubung 35 gespannt wird. Auch hier, wie auch bei den vorherigen und folgenden Ausführungsbeispielen, können statt einer Verschraubung auch andere Mittel zur Krafterzeugung genutzt werden, wobei auch die (nachträgliche) Einstellbarkeit der Kraft auch kein notwendiges Merkmal ist. Das Spannelement 34 weist in diesem Ausführungsbeispiel zum Anderen im Wesentlichen keine nachgiebige Strukturen auf.

Im Rahmen einer Abwandlung (nicht dargestellt) dieses Ausführungsbeispiels könnte die Verschraubung auch über die Basis 33 eingeführt werden, während sich dann die Blattfeder als das separate Federelement an dem Hauptabschnitt des Spannelements 34 abstützt.

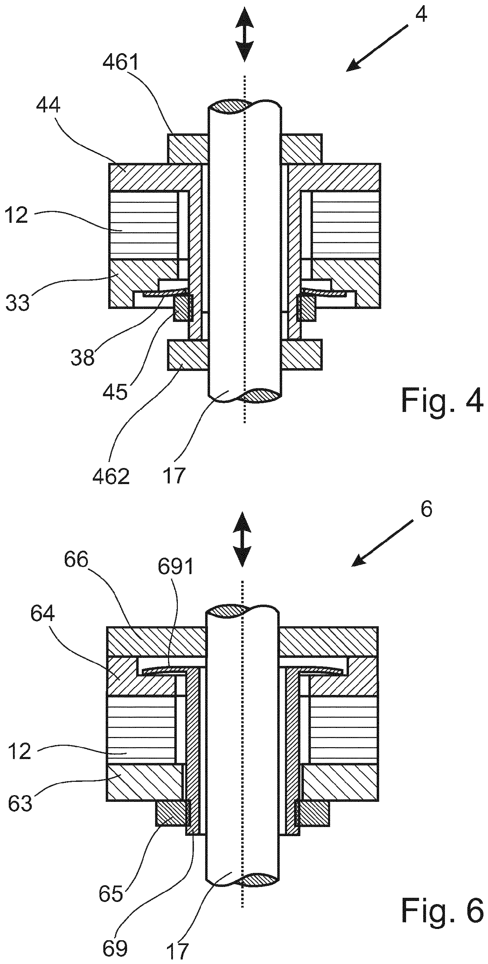

Fig. 4 zeigt eine schematische Querschnittdarstellung zur Illustration eines vierten Ausführungsbeispiels der erfindungsgemäßen Trägheitsantriebsvorrichtung

Die Trägheitsantriebsvorrichtung 4 des vierten Ausführungsbeispiels ergibt sich durch eine Erweiterung der Trägheitsantriebsvorrichtung 3 des dritten Ausführungsbeispiels. Im Unterschied zum dritten Ausführungsbeispiel wird ist das Spannelement 44 über die Verschraubung 45 hinaus erweitert und damit an beiden Enden mit jeweils mindestens einem kraftübertragenden Objekt oder Reibelement 461, 462 verbunden, so dass das zu positionierende Objekt 17 über die Länge des Antriebs in den Reibelementen 461, 462 geführt wird.

Fig. 5 zeigt eine schematische Querschnittdarstellung zur Illustration eines fünften Ausführungsbeispiels der erfindungsgemäßen Trägheitsantriebsvorrichtung.

Auch die Trägheitsantriebsvorrichtung 5 des fünften Ausführungsbeispiels ergibt sich durch eine Erweiterung der Trägheitsantriebsvorrichtung 3 des dritten Ausführungsbeispiels. In diesem Fall liegt der wesentliche Unterschied in einer hinzugefügten Wälzlagerführung 59, welche externe Kräfte aufnehmen kann, ohne die Bewegungsrichtung (entlang des Doppelpfeils) zu hemmen. Der Einsatz einer solchen Führung ist vorteilhaft, wenn der Antrieb Kräften ausgesetzt ist, die nicht entlang der Bewegungsrichtung wirken.

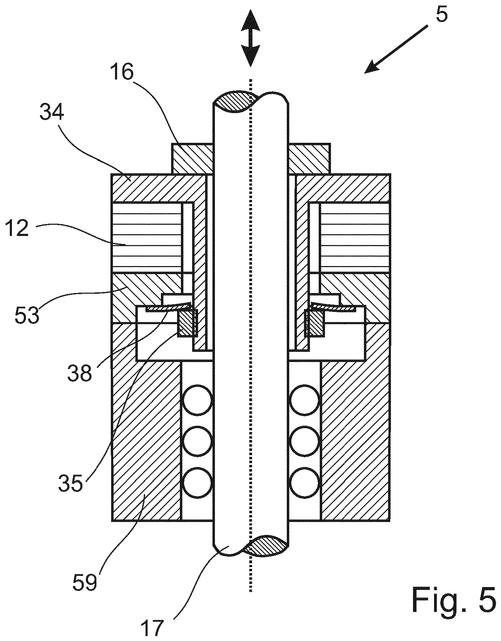

Fig. 6 zeigt eine schematische Querschnittdarstellung zur Illustration eines sechsten Ausführungsbeispiels der erfindungsgemäßen Trägheitsantriebsvorrichtung.

Wie schon bei den vorherigen Ausführungsbeispielen umfasst die Trägheitsantriebsvorrichtung 6 einen einen Innenbereich definierenden Aktuator 12, der hier allerdings einerseits von einer Basis 63 und andererseits von einem Übergangselement 64 eingefasst ist. Ein Spannelement 69 mit einem integralen Federelement 691 greift in eine Ausnehmung des Übergangselements 64 ein und steht zudem über eine Verschraubung 65 mit der Basis 63 in Eingriff.

Beim sechsten Ausführungsbeispiel ist das derart mit dem Aktuator 12 verbundene Übergangselement 64 klein gehalten. Das durch den Aktuator 12 hindurchgreifende Spannelement 69 besitzt mit dem integralen Federelement 691 einen elastischen Bereich ausgestattet, der sich in dem Übergangselement 64 abstützt. Durch das Anziehen der Verschraubung 65 wird der elastische Bereich (das integrale Federelement 691) gespannt und damit der Aktuator 12 vorgespannt.

Auch hier muss der federnde Bereich nicht unbedingt auf der beweglichen Seite, also am Übergangselement 64 angeordnet sein. Der federnde Bereich könnte ich genauso auf der stationären Seite an der Basis 63 abstützen. Vorteilhaft ist aber die federnde Struktur am beweglichen Übergangselement 64 anzuordnen, da dadurch die Gesamtmasse der bewegten Masse geringer wird.

Der federnde Teil muss nicht ein integraler Bestandteil des Spannelements 69 sein. Stattdessen kann z.B. ebenfalls eine separate Federstruktur, wie z.B. eine Tellerfeder eingesetzt werden.

Ebenso muss der elastische Bereich des integralen Federelements 691 des Spannelements 69 nicht wie dargestellt als biegeelastisch ausgeführt sein. Es sind auch beliebige andere Ausführungen denkbar, wie z.B. die anhand des ersten Ausführungsbeispiels erläuterte Streckung.

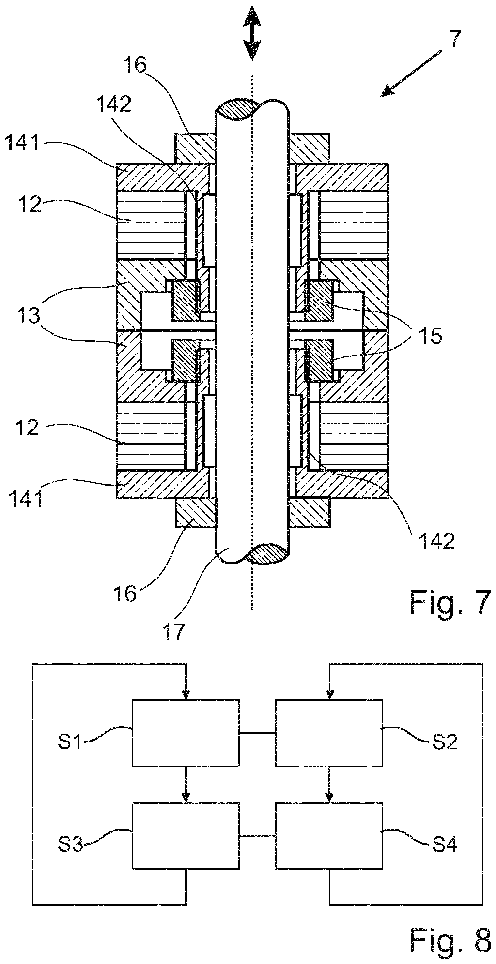

Fig. 7 zeigt eine schematische Querschnittdarstellung zur Illustration eines Ausführungsbeispiels des erfindungsgemäßen Trägheitsantriebssystems.

Das Trägheitsantriebssystem 7 dieses Ausführungsbeispiels umfasst eine Kombination - in gegensinniger Anordnung - von zwei Trägheitsantriebsvorrichtungen gemäß dem ersten Ausführungsbeispiel, womit auf Basis des ersten Ausführungsbeispiels angedeutet werden soll, wie erfindungsgemäße Antriebe miteinander kombiniert werden können, um einen Mehraktuatorantrieb zu erzeugen. Eine derartige Kombination ist nicht auf gleichartige Ausführungsbeispiele beschränkt.

Im Trägheitsantriebssystem 7 sind die jeweils stationären Komponenten in Form der jeweiligen Basis 13 der Trägheitsantriebsvorrichtungen 1 miteinander verbunden. Somit stehen zwei Reibelemente 16 als kraftübertragenden Komponenten in Reibkontakt mit dem zu positionierenden Objekt 17.

Das zu positionierende Objekt 17 kann, wie für Mehraktuatorantriebe üblich, über verschiedenen Kurvensignale angesteuert werden. So ist es z.B. möglich, an die beiden Aktuatoren Signale anzulegen, die zueinander invertiert aber in Phase sind. Von Vorteil mag es sein, wenn die Signale nicht in Phase liegen, um Vibration zu dämpfen.

Fig. 8 zeigt ein schematisches Ablaufdiagramm eines Ausführungsbeispiels des erfindungsgemäßen Verfahrens zur Positionierung eines Objekts.

Im Rahmen des erfindungsgemäßen Verfahrens zur Positionierung eines Objekts wird eine Trägheitsantriebsvorrichtung mit einem piezoelektrischen oder elektrostriktiven Aktuator, der einen Innenbereich definiert, in den hinein oder durch den hindurch sich das zu positionierende Objekt erstreckt, einem mit dem Aktuator verbundenen Reibelement im Reibkontakt mit dem zu positionierenden Objekt und einem Spannelement, das zumindest zum Teil im Innenbereich angeordnet ist, eingesetzt.

Durch Strecken oder Ausdehnen des Aktuators (durch eine geeignete Ansteuerung) mit einer so dimensionierten Beschleunigung, so dass es nicht zu einem Durchrutschen (also einer Überwindung der Haftreibung) zwischen dem Reibelement und dem zu positionierenden Objekt kommt, wird das zu positionierende Objekt bewegt (Schritt S1). Hierbei kommt es zudem zu einer Spannung (S2) des Spannelements, das damit eine Druckspannung auf den Aktuator ausübt.

Durch eine vergleichsweise hohe Beschleunigung beim Kürzen oder Zusammenziehen des Aktuators (wiederum durch eine geeignete Ansteuerung) kommt es zu einem Durchrutschen von Reibelement und zu positionierenden Objekt, wobei unter Nutzung der Trägheit des zu positionierenden Objekts die Haftreibung überwunden wird (Schritt S3). Bei dem Kürzen oder Zusammenziehen ist der Aktuator auf Zug belastet, wobei durch die von dem Spannelement ausgeübte Druckspannung diese Zugbelastung verringert wird. Das Spannelement entspannt sich hierbei in vorbestimmter Weise (Schritt S4). Die Schritte des Streckens und Kürzens des Aktuators und dementsprechend auch des Spannen und Entspannens des Spannelements wiederholen sich bis zur gewünschten Positionierung.

Das Verfahren umfasst also, dass das Spannelement zumindest bei gestreckten Aktuator auf wenigstens einen Teil des Aktuators eine der Streckung des Aktuators entgegen gerichtete Druckspannung ausübt.

Auch wenn in den Figuren verschiedene Aspekte oder Merkmale der Erfindung jeweils in Kombination gezeigt sind, ist für den Fachmann - soweit nicht anders angegeben - ersichtlich, dass die dargestellten und diskutieren Kombinationen nicht die einzig möglichen sind. Insbesondere können einander entsprechende Einheiten oder Merkmalskomplexe aus unterschiedlichen Ausführungsbeispielen miteinander ausgetauscht werden.

### Bezugszeichenliste

- 1, 2, 3, 4, 5, 6: Trägheitsantriebsvorrichtung
- 7: Trägheitsantriebssystem
- 12: Aktuator
- 13, 33, 53, 63: Basis
- 14, 24, 34, 44, 69: Spannelement
- 15, 25, 35, 45, 65: Verschraubung
- 16, 26, 66, 461, 462: Reibelement
- 17: zu positionierendes Objekt
- 38: separates Federelement
- 59: Wälzlagerführung
- 64: Übergangselement
- 141, 241: Kontaktteil
- 142, 242, 691: integrales Federelement
- 161: Reibkontakt
- 162: Ausleger

## Patentansprüche

1. Trägheitsantriebsvorrichtung (1, 2, 3, 4, 5, 6) zur Positionierung eines Objekts (17), mit
einem piezoelektrischen oder elektrostriktiven Aktuator (12), der einen Innenbereich ganz oder teilweise umschließt, wobei sich das zu positionierende Objekt (17) im Betriebszustand der Trägheitsantriebsvorrichtung (1, 2, 3, 4, 5, 6) durch den Innenbereich hinein oder hindurch erstreckt,
einem mit dem Aktuator (12) verbundenen Reibelement (16, 26, 66, 461, 462), das für einen Reibkontakt mit dem zu positionierenden Objekt (17) ausgestaltet ist, und
einem Spannelement (14, 24, 34, 44, 69), das ausgestaltet ist, zumindest bei gestrecktem Aktuator (12) auf wenigstens einen Teil des Aktuators (12) eine der Streckung des Aktuators (12) entgegen gerichtete Druckspannung auszuüben,
wobei zumindest ein Teil des Spannelements (14, 24, 34, 44, 69) im Innenbereich angeordnet ist.

2. Trägheitsantriebsvorrichtung (1, 2, 3, 4, 5, 6) nach Anspruch 1,
wobei das Reibelement und das Spannelement integral ausgeführt sind.

3. Trägheitsantriebsvorrichtung (1, 2, 3, 4, 5) nach Anspruch 1,
wobei das Reibelement (16, 26, 461, 462) über das Spannelement (14, 24, 34, 44) mit dem Aktuator (12) verbunden ist.

4. Trägheitsantriebsvorrichtung (1, 2, 3, 4, 5, 6) nach Anspruch 1,
wobei das Spannelement ausgestaltet ist, die Druckspannung über das mit dem Aktuator (12) verbundene Reibelement auf den Aktuator (12) auszuüben.

5. Trägheitsantriebsvorrichtung (6) nach Anspruch 1,
wobei das Reibelement (66) unabhängig vom Spannelement (69) mit dem Aktuator (12) verbunden ist und das Spannelement (69) dazu ausgestaltet ist, die Druckspannung unabhängig vom Reibelement (66) auszuüben.

6. Trägheitsantriebsvorrichtung (1, 2, 3, 4, 5, 6) nach einem der vorstehenden Ansprüche,
wobei das Spannelement (14, 24, 34, 44, 69) für eine einstellbare Druckspannung ausgestaltet ist und insbesondere mit einer zur Einstellung der Druckspannung vorgesehenen Verschraubung (15, 25, 35, 45, 65) ausgestattet ist.

7. Trägheitsantriebsvorrichtung (1, 2, 3, 4, 5, 6) nach einem der vorstehenden Ansprüche,
wobei das Spannelement (14, 24, 34, 44, 69) zur Bewirkung der Druckspannung ein integrales Federelement (142, 242, 691), insbesondere infolge einer Dehnung, Biegung und/oder Torsion, und/oder ein separates Federelement (38) aufweist.

8. Trägheitsantriebsvorrichtung (1, 2, 3, 4, 5, 6) nach einem der vorstehenden Ansprüche,
wobei das Reibelement (16, 26, 66, 461, 462) für eine Einstellbarkeit einer Reibungskraft zwischen dem Reibelement (16, 26, 66, 461, 462) und dem zu positionierenden Objekt (17) ausgestaltet ist.

9. Trägheitsantriebssystem (7) mit wenigstens zwei miteinander verbundenen Trägheitsantriebsvorrichtungen (1, 2, 3, 4, 5, 6), jeweils nach einem der vorstehenden Ansprüche.

10. Verfahren zur Positionierung eines Objekts (17) mit einer Trägheitsantriebsvorrichtung (1, 2, 3, 4, 5, 6) mit einem piezoelektrischen oder elektrostriktiven Aktuator (12), der einen Innenbereich ganz oder teilweise umschließt, in den hinein oder durch den hindurch sich das zu positionierende Objekt (17) erstreckt, einem mit dem Aktuator (12) verbundenen Reibelement (16, 26, 66, 461, 462) im Reibkontakt mit dem zu positionierenden Objekt (17) und einem Spannelement (14, 24, 34, 44, 69), das zumindest zum Teil im Innenbereich angeordnet ist,
wobei das Verfahren umfasst, dass das Spannelement (14, 24, 34, 44, 69) zumindest bei gestreckten Aktuator (12) auf wenigstens einen Teil des Aktuators (12) eine der Streckung des Aktuators (12) entgegen gerichtete Druckspannung ausübt.

## Claims

1. Inertia drive device (1, 2, 3, 4, 5, 6) for positioning an object (17), having
a piezoelectric or electrostrictive actuator (12) which completely or partially surrounds an inner region, wherein the object (17) to be positioned extends in the operating state of the inertia drive device (1, 2, 3, 4, 5, 6) into or through the inner region,
a friction element (16, 26, 66, 461, 462) which is connected to the actuator (12) and which is configured for friction contact with the object (17) to be positioned, and
a clamping element (14, 24, 34, 44, 69) which is configured at least with an extended actuator (12) to apply to at least a portion of the actuator (12) a compression stress which is directed counter to the extension of the actuator (12),
wherein at least a portion of the clamping element (14, 24, 34, 44, 69) is arranged in the inner region.

2. Inertia drive device (1, 2, 3, 4, 5, 6) according to claim 1, wherein the friction element and the clamping element are configured in an integral manner.

3. Inertia drive device (1, 2, 3, 4, 5) according to claim 1, wherein the friction element (16, 26, 461, 462) is connected to the actuator (12) by means of the clamping element (14, 24, 34, 44) .

4. Inertia drive device (1, 2, 3, 4, 5, 6) according to claim 1, wherein the clamping element is configured to apply the compression stress to the actuator (12) via the friction element which is connected to the actuator (12).

5. Inertia drive device (6) according to claim 1,
wherein the friction element (66) is connected to the actuator (12) independently of the clamping element (69) and the clamping element (69) is configured to apply the compression stress independently of the friction element (66).

6. Inertia drive device (1, 2, 3, 4, 5, 6) according to any one of the preceding claims,
wherein the clamping element (14, 24, 34, 44, 69) is configured for an adjustable compression stress and is in particular provided with a screw connection (15, 25, 35, 45, 65) which is provided to adjust the compression stress.

7. Inertia drive device (1, 2, 3, 4, 5, 6) according to any one of the preceding claims,
wherein the clamping element (14, 24, 34, 44, 69) has in order to bring about the compression stress an integral resilient element (142, 242, 691), in particular as a result of an expansion, bending and/or torsion, and/or a separate resilient element (38).

8. Inertia drive device (1, 2, 3, 4, 5, 6) according to any one of the preceding claims,
wherein the friction element (16, 26, 66, 461, 462) is configured for an adjustability of a friction force between the friction element (16, 26, 66, 461, 462) and the object (17) which is intended to be positioned.

9. Inertia drive system (7) having at least two inertia drive devices (1, 2, 3, 4, 5, 6) which are connected to each other each according to any one of the preceding claims.

10. Method for positioning an object (17) by means of an inertia drive device (1, 2, 3, 4, 5, 6) having a piezoelectric or electrostrictive actuator (12) which completely or partially surrounds an inner region into which or through which the object (17) to be positioned extends, a friction element (16, 26, 66, 461, 462) which is connected to the actuator (12) in friction contact with the object (17) to be positioned, and a clamping element (14, 24, 34, 44, 69) which is at least partially arranged in the inner region, wherein the method involves the clamping element (14, 24, 34, 44, 69) at least with an extended actuator (12) applying to at least a portion of the actuator (12) a compression stress which is directed counter to the extension of the actuator (12) .

## Revendications

1. Dispositif d'entraînement par inertie (1, 2, 3, 4, 5, 6) pour positionner un objet (17), avec
un actionneur (12) piézoélectrique ou électrostrictif, qui renferme en totalité ou en partie une zone intérieure, dans lequel l'objet (17) à positionner s'étend à travers la zone intérieure à l'intérieur de celle-ci ou de part en part dans l'état de fonctionnement du dispositif d'entraînement par inertie (1, 2, 3, 4, 5, 6),
un élément de frottement (16, 26, 66, 461, 462) relié à l'actionneur (12), qui est configuré pour un contact par frottement avec l'objet (17) à positionner, et
un élément de serrage (14, 24, 34, 44, 69), qui est configuré pour exercer une tension de pression dirigée dans le sens opposé à l'extension de l'actionneur (12) sur au moins une partie de l'actionneur (12) au moins lorsque l'actionneur (12) est étiré,
dans lequel au moins une partie de l'élément de serrage (14, 24, 34, 44, 69) est disposée dans la zone intérieure.

2. Dispositif d'entraînement par inertie (1, 2, 3, 4, 5, 6) selon la revendication 1,
dans lequel l'élément de frottement et l'élément de serrage sont réalisés de manière intégrale.

3. Dispositif d'entraînement par inertie (1, 2, 3, 4, 5) selon la revendication 1,
dans lequel l'élément de frottement (16, 26, 461, 462) est relié à l'actionneur (12) par l'intermédiaire de l'élément de serrage (14, 24, 34, 44).

4. Dispositif d'entraînement par inertie (1, 2, 3, 4, 5, 6) selon la revendication 1,
dans lequel l'élément de serrage est configuré pour exercer la tension de pression sur l'actionneur (12) par l'intermédiaire de l'élément de frottement relié à l'actionneur (12).

5. Dispositif d'entraînement par inertie (6) selon la revendication 1,
dans lequel l'élément de frottement (66) est relié à l'actionneur (12) indépendamment de l'élément de serrage (69) et l'élément de serrage (69) est configuré pour exercer la tension de pression indépendamment de l'élément de frottement (66).

6. Dispositif d'entraînement par inertie (1, 2, 3, 4, 5, 6) selon l'une quelconque des revendications précédentes,
dans lequel l'élément de serrage (14, 24, 34, 44, 69) est configuré pour une tension de pression réglable et en particulier est équipé d'un vissage (15, 25, 35, 45, 65) prévu pour régler la tension de pression.

7. Dispositif d'entraînement par inertie (1, 2, 3, 4, 5, 6) selon l'une quelconque des revendications précédentes,
dans lequel l'élément de serrage (14, 24, 34, 44, 69) présente, pour provoquer la tension de pression, un élément de ressort intégral (142, 242, 691), en particulier suite à un allongement, flexion et/ou torsion, et/ou un élément de ressort séparé (38).

8. Dispositif d'entraînement par inertie (1, 2, 3, 4, 5, 6) selon l'une quelconque des revendications précédentes,
dans lequel l'élément de frottement (16, 26, 66, 461, 462) est configuré pour une possibilité de régler une force de friction entre l'élément de frottement (16, 26, 66, 461, 462) et l'objet (17) à positionner.

9. Dispositif d'entraînement par inertie (7) avec au moins deux dispositifs d'entraînement par inertie (1, 2, 3, 4, 5, 6) reliés l'un à l'autre respectivement selon l'une quelconque des revendications précédentes.

10. Procédé pour positionner un objet (17) avec un dispositif d'entraînement par inertie (1, 2, 3, 4, 5, 6) avec un actionneur (12) piézoélectrique ou électrostrictif, qui renferme en totalité ou en partie une zone intérieure, à l'intérieur de laquelle ou à travers laquelle de part en part s'étend l'objet (17) à positionner, un élément de frottement (16, 26, 66, 461, 462) relié à l'actionneur (12) en contact par frottement avec l'objet (17) à positionner, et un élément de serrage (14, 24, 34, 44, 69) qui est disposé au moins en partie dans la zone intérieure,
dans lequel le procédé comprend que l'élément de serrage (14, 24, 34, 44, 69) exerce une tension de pression dirigée dans le sens opposé à l'extension de l'actionneur (12) sur au moins une partie de l'actionneur (12) au moins lorsque l'actionneur (12) est étiré.
